# EUROPEAN PATENT APPLICATION

(11) **EP 2 860 769 A1**
(43) Date of publication of application: **15.04.2015**
(21) Application number: 13188300.1
(22) Date of filing: 11.10.2013
(51) Int. Cl.: H01L 33/00, H01L 33/38, H01L 33/42, H01L 33/62, H01L 33/32, H01L 33/40, H01L 33/44, H01L 33/46

(54) **Layer structure for surface-emitting thin-film p-side-up light-emitting diode**

(71) Applicant: Azzurro Semiconductors AG, 01237 Dresden (DE)
(72) Inventor: Chitnis, Ashay Dr., 01309 Dresden (DE); Pinos, Andreas Dr., 01257 Dresden (DE); Lutgen, Stephan Dr., 01309 Dresden (DE); Tan, Wei-Sin Dr., 01309 Dresden (DE)
(74) Representative: Eisenführ Speiser

(57) **Abstract**

A layer structure 100 for a surface-emitting LED having an emission surface 101 that is closer to a p-side of the structure than to an n-side of the structure, and further comprising a transparent anode layer 110, a p-type layer 120, a light-emitting group-III-nitride structure 130, an n-type layer 140, a cathode layer 150, an electrically insulating layer 160 under the cathode layer, a metallically conductive anode contact substrate 170 under the insulating layer, at least one vertical interconnect 175 electrically connecting the anode contact substrate and the anode layer, a metallically conductive cathode contact substrate 180 electrically connected with and arranged under the cathode layer, wherein either the insulating layer or the cathode layer is reflective, and wherein the cathode contact substrate and/or the anode contact substrate have a suitable thickness for forming a mechanical support of the layer structure.

## Description

The present invention relates to a layer structure for a surface-emitting light-emitting diode. It also relates to a surface-emitting light-emitting diode comprising such a layer structure, and to a fabrication method for such a layer structure.

Semiconductor surface-emitting light emitting diodes (LEDs) are widely used. The use of p-side down structures with roughened thick n-type layers is common, especially in the field of the group-III-nitride material system using silicon as a growth substrate.

Surface-emitting LEDs usually have contact pads on their emission surface. Especially for high-power LEDs large-area contact-pads are a requirement, which limits the light-emitting area and in turn also the luminous efficiency.

US 7,964,881 B2 describes a LED structure aiming at providing a particularly large light-emitting area. A semiconductor layer of an undefined first conductivity type forms the emission surface and is electrically connected with an electrically conductive substrate arranged opposite to the emission surface by vertical contact holes extending from the semiconductor layer to a first electrode layer arranged directly on the substrate. For electrically connecting a semiconductor layer of the opposite conductivity type with its electrode layer, a hole is arranged in the emission surface that extends through an active layer down to a second electrode layer.

According to a first aspect of the present invention a layer structure for a surface-emitting LED having an emission surface that is closer to a p-side of the layer structure than to an n-side of the layer structure further comprises
- an anode layer that is transparent for the light to be emitted,
- a p-type layer made of a first group-III-nitride material under the anode layer, that is, arranged at a larger distance from the emission surface than the anode layer,
- an active group-III-nitride layer structure under the p-type group-III-nitride layer and configured to generate the light to be emitted in operation of the LED,
- an n-type layer made of a second group-III-nitride material under the active layer,
- a cathode layer under the n-type layer,
- an electrically insulating isolation layer arranged under the cathode layer,
- a metallically conductive anode contact substrate arranged under the isolation layer and is electrically isolated from the cathode layer by the isolation layer,
- at least one vertical interconnect extending between and electrically connecting the anode contact substrate and the anode layer,
- a metallically conductive cathode contact substrate that is electrically connected with the cathode layer and arranged under cathode layer,
wherein either the isolation layer or the cathode layer is reflective for the light to be emitted, and wherein
either the cathode contact substrate or the anode contact substrate or both the cathode contact substrate and the anode contact substrate have a thickness that is suitable for forming a mechanical support of the layer structure.

The layer structure of the present invention is especially designed for a surface-emitting p-side-up LED. This is expressed by the above wording that the emission surface is closer to a p-side of the layer structure than to an n-side of the layer structure. In other words, the emission surface is on the p-side of the LED. The position of the emission surface with respect to the layer structure defines the meaning of "up" for the purpose of the present specification. Thus, the emission surface may be oriented facing down to the ground in operation of the LED, but in terms of the present specification is still "up". Based on this usage of terms, the present specification uses the term "under" to indicate a layer arrangement, in which a first layer that is arranged under a second layer has a larger vertical distance from the emission surface than the first layer. Positional relationships defined by "under" and "over" include embodiments implementing the meaning "immediately under/over", but are to be understood as also including embodiments that have an arrangement comprising intermediate layers between the two layers mentioned as being arranged under or over each other. If the latter form of embodiments with intermediate layer is to be excluded, this is specified, for instance by "directly" (e.g., "directly under") or "immediately" (e.g., "immediately over").

The emission surface forms an interface of the layer structure, through which light to be emitted enters an external environment, i.e., is emitted. The external environment, by way of example, may be a gas such as air, or an organic material such as epoxy or silicones, or an external device interface such as an interface of a coupler for coupling the emitted light into an optical light guide.

By arranging both cathode and anode contact substrates on the side opposite to the emission surface, i.e., on the bottom side of the layer structure, and by providing a vertical interconnect opaque contacts on the emission surface as well as a contact hole in the emission surface can be avoided.

In particular, the arrangement of the cathode (n-type) contact substrate on the bottom side of the layer structure allows providing it with an area that is much larger than suitable in a layer structure according the prior art described above. This improves the current-spreading, which allows providing an only thin n-type group-III nitride layer in preferred embodiments. In contrast, due to the limited lateral extension of their contact pad area, the prior art structure requires a thick n-type group-III nitride layer for achieving good current spreading. However, due to the well-known difficulties of growing group-III-nitrides on foreign substrates such as SiC, sapphire, and in particular silicon, such thick n-type layers bear a strong risk of causing undesired bow and cracking. The layer structure according to the present invention avoids these risks and thus relaxes the stress management requirements during the growth of the group-III-nitride materials. The layer structure is mechanically stabilized by the contact substrates having sufficient thicknesses and areas to mechanically stabilize. This has the additional effect, that uniform current spreading is allowed and heat dissipation is improved. The term "anode/cathode contact substrate" is chosen to illustrate that these structural elements integrate at least two functions, namely, providing mechanical stability to the layer structure, which typically is a thin-film LED layer structure, and providing electrical contact faces for applying an operational voltage to the layer structure using an external voltage supply.

In the following, embodiments of the layer structure of the present invention will be described.

The active group-III-nitride layer structure comprises, in a particularly simple embodiment, a single p-n-junction. However, for achieving good luminous efficiency, the active layer stack is preferably formed by a multi-layer stack, in particular a multi-quantum well structure comprising well layers and barrier layers. Such structures are per se known in the prior art. Suitable group-III-nitride materials for use in the active group-III-nitride layer structure are for example InGaN, InAlGaN and InN and are selected depending, among others, on the desired emission wavelength.

The respective first and second group-III-nitride materials of the p- and n-type layers are suitably selected to have a larger band-gap than the emitting material of the active group-III-nitride layer structure, in order to improve carrier capture and to allow the light to be emitted pass through these layers with no or very low absorption. The first and the second group-III-nitride material are preferably chosen from a group comprising GaN, InGaN, AlGaN, InAlGaN. The first and the second group-III-nitride material are identical in one embodiment. However, in another embodiment the layer structure has a first group-III-nitride material that is different from the second group-III-nitride material.

Suitable materials for the anode layer are conductive and transparent for the light to be emitted. Such materials comprise for instance conductive oxides as for example indium tin oxide (ITO) and fluorine tin oxide (FTO) and metal based transparent contacts like for example Ni, Pd, Pt, and Au-based transparent contacts.

In one embodiment of the invention the n-type group-III nitride layer has a thickness in a range of 1 to 4 µm. A lower limit for a suitable layer thickness of the n-type group-III nitride layer is the depletion width in the n-layer in order to avoid performance losses of the active group-III-nitride layer structure. Higher layer thicknesses can also be used but increase the risk of cracking.

Suitable thicknesses of the contacts substrates are typically in the range of 20 to 50 µm, but also other thicknesses can be favorable.

In one embodiment, the cathode contact substrate is arranged at a lateral distance from the anode contact substrate. In particular, the cathode contact substrate and the anode contact substrate are preferably arranged on a bottom surface of the layer structure and laterally separated by a either gap or a dielectric material filling. Thus, the cathode contact substrate and the anode contact substrate are electrically isolated from each other by the lateral space between them. The use of an additional isolating material between the cathode contact substrate and the anode contact substrate is also suitable.

The vertical interconnect preferably takes the form of at least one Via. The Via comprises in one embodiment a passivation layer of isolating material on an inner sidewall of a Via channel and a Via filling with an electrically conductive material. The diameter of the vertical interconnect is preferably in a range of 20 to 30 µm.

In one embodiment the vertical interconnect protrudes into the anode contact substrate or into the anode layer or into the anode contact substrate and the anode layer. In a further embodiment the vertical interconnects contacts the anode contact substrate or the anode layer or the anode contact substrate and the anode layer without protruding into the anode contact substrate by extending to a respective surface of the anode contact substrate or the anode layer or the anode contact substrate and the anode layer.

The electrically conductive Via filling is for instance made of a transparent conductive oxide, for example ITO or FTO. In other embodiments, a metallic material as for example Ag or Al is used. The use of transparent conductive oxides is advantageous in order to minimize optical losses, especially in embodiments where the Via extends into the anode layer. Metallic materials allow achieving a very low electrical resistance between the anode layer and the anode contact substrate.

The bottom surface is plane in some embodiments. In other embodiments it includes a step. The arrangement of the cathode contact substrate and the anode contact substrate at a lateral distance from each other and at least roughly on the same plane improves the mechanical support of the layer structure.

In different advantageous embodiments of the layer structure, the lateral extension of the anode contact substrate, or the lateral extension of the cathode contact substrate, or the lateral extensions of the anode contact substrate and the lateral extension of the cathode contact substrate exceed, in at least one lateral direction, the respective lateral extension of the layers arranged vertically over the anode contact substrate and the cathode contact substrate. As a consequence, a part of the respective contact substrate, cathode or anode, or of both contact substrates, cathode and anode, protrudes laterally from the layer structure. The protruding part or part, which laterally extends or extend beyond the layers arranged vertically on top of the anode contact substrate and the cathode contact substrate can be advantageously used for electrically connecting an LED incorporating the layer structure. These embodiments allow a simplified process for electrically connecting bond wires or other electrical connection means to the LED. Respective bond wires can be connected to the protruding area of the respective contact substrate, cathode or anode. In alternative embodiments, either the anode contact substrate or the cathode contact substrate or both contact substrates take the form of blanket contacts of the suitable thickness.

In other embodiments, either the anode contact substrate or the cathode contact substrate or both contact substrates take the form of bumps. Bumps are known per se in the art, and may be formed or placed in many different ways, including evaporation, electroplating, printing, jetting, stud bumping, and direct placement. The use of bumps allows for reproducible snap breaking for die singulation with low cost equipment and minimum loss of functional layer structure. In some variants, the bumps are additionally patterned. In one embodiment, a dielectric layer is arranged on top of the anode layer.

In a variant of this embodiment, the dielectric layer has a micro-structured surface that forms the emission surface. A micro-structured surface of the dielectric layer further improves the light extraction efficiency of the layer structure. The micro-structuring of the surface is in some variants designed to reduce the emission aperture, i.e., increase the directionality of light emission. Different embodiments employing such micro-structured dielectric layer have a regular surface pattern of the dielectric layer, which may be fabricated using masked etching, or an irregularly roughened surface of the dielectric layer, which can be obtained by unmasked mechanical, chemical or combined chemical and mechanical surface treatment.

In one embodiment the cathode layer is a metal mirror layer that is reflective for the light to be emitted. This measure improves the light extraction efficiency. In this embodiment, the cathode contact substrate is preferably arranged directly adjacent to the cathode layer.

However, in alternative embodiments, the cathode layer is made of an electrically conductive material that is transparent for the light to be emitted, and the isolating layer is a reflector layer, for instance a distributed bragg reflector, and extends not only between the cathode layer and the anode contact substrate, but also between the cathode layer and the cathode contact substrate. In this embodiment, the cathode contact substrate and the cathode layer are preferably connected with each other through a vertical interconnect, in particular a Via. While allowing a very high reflective mirror structure over the whole lateral extension, and thus a high light extraction efficiency of the layer structure, this embodiment also allows fabricating the anode contact substrate and the cathode contact substrate on the same surface plane of the isolating layer.

In a further embodiment an additional current spreading layer is arranged either directly on top of or directly under the anode layer. Favorably the current spreading layer is a thin transparent metal layer. The current spreading layer further improves the current spreading of the anode layer and thus further increases the efficiency of a LED.

The layer structure of the present invention or one of its embodiments disclosed herein is preferably incorporated in a surface-emitting light-emitting diode, that forms a second aspect of the present invention. Such a surface-emitting LED thus includes the layer structure or one of its embodiments described herein. In addition to the advantages of these respective embodiments, the LED avoids complicated and space-intensive wire bonding in the step of device packaging, due to the formation of the anode and cathode contacts in the form of contact substrates.

In one embodiment the surface-emitting LED comprises submounts as packaging contacts connected with the anode contact substrate and the cathode contact substrate.

In one embodiment of the surface-emitting LED the lateral dimensions of the anode contact substrate or the lateral dimensions of the cathode contact substrate or the lateral dimensions of the anode contact substrate and the lateral dimensions of the cathode contact substrate exceed laterally in at least one direction the lateral dimensions the other layers of the LED in such a way that parts of the respective substrate are not covered by the layers arranged above the substrates in the layer structure and thus can be contacted for example by bond wires at the exposed parts of the substrate.

In a third aspect, the invention provides a method for fabricating a layer structure for a surface-emitting light-emitting diode, hereinafter LED. The method comprises
- providing a template comprising, on a growth substrate in order of layer deposition, an n-type layer made of a second group-III-nitride material, an active group-III-nitride layer structure configured to generate the light to be emitted in operation of the LED, and a p-type layer made of a first group-III-nitride material,
- depositing on the p-type layer an anode layer that is transparent for the light to be emitted,
- bonding a temporary carrier to the anode layer,
- removing the growth substrate and exposing the n-type layer;
- depositing a cathode layer on the n-type layer;
- depositing an isolation layer at least partially on the cathode layer
- fabricating at least one vertical interconnect, hereinafter Via, vertically extending through the isolation layer and to the anode layer;
- depositing an anode contact substrate on the isolation layer and in electrical contact with the Via,
- depositing a cathode contact substrate either on the isolation layer or on the cathode layer, and
- removing the temporary carrier.

The method shares the advantages of the layer structure of the first aspect of the invention and of the LED of the second aspect of the invention.

In one embodiment of the method the described manufacturing steps proceed in temporal order as listed above. In a further embodiment of the method, the fabrication of the vertical interconnect is done before the deposition of the anode layer. In this embodiment the vertical interconnect extends at the point of its fabrication through the p-type-layer, the active layer structure and the n-type layer in such a way that after the later deposition of the anode contact and the anode contact substrate the anode contact substrate and the anode layer are electrically connected to each other.

Providing the template is in one embodiment implemented by fabricating the template. In another embodiment, a prefabricated template available from a template manufacturer is used.

The vertical interconnect is preferably fabricated in the form of at least one Via. The fabrication of a Via comprises, in some embodiments, anisotropically etching a channel, passivating the channel by depositing isolating material on an inner sidewall of the channel, and filling the channel with an electrically conductive material, e.g., with ITO or FTO, or Ag or Al.

In one embodiment of the method, the template provided at the outset of the proceedings comprises a seed and buffer layer structure directly on a silicon or other foreign growth substrate. Exposing the n-type layer in this type of embodiment preferably comprises removing the seed and buffer layer structure in addition to removing the growth substrate. Seed and buffer layer structures are used for growing high quality group-III-nitride layer structures on Si and other foreign substrates.

Advantageously, depositing the anode contact substrate or the cathode contact substrate comprises depositing a metal bump. Additionally patterning the deposited bump forms a variant of this embodiment.

In another embodiment the method comprises depositing a micro-structured dielectric layer on the anode layer after removing the temporary carrier.

Preferably, the method comprises fabricating the isolation layer such that it laterally covers the whole cathode layer, followed by fabricating at least one additional via channel extending from the isolation layer to the cathode layer and depositing the cathode contact substrate on the isolation layer.

In one embodiment the method further comprises a die singulation step. This die singulation step in one embodiment takes place after the deposition of the anode contact substrate and the cathode contact substrate. In another embodiment the deposition of the anode contact substrate or the cathode contact substrate or the anode contact substrate and the cathode contact substrate are realized after the die singulation.

This embodiment of the method is advantageous especially for manufacturing a layer structure in which the lateral dimensions of the anode contact substrate or the lateral dimensions of the cathode contact substrate or the lateral dimensions of the anode contact substrate and the lateral dimensions of the cathode contact substrate exceed laterally in at least one direction the lateral dimensions of the layers arranged vertically over the anode contact substrate and the cathode contact substrate.

Further embodiments of the invention will be described hereinafter with reference to the drawings, in which:
Fig. 1 shows an embodiment of a layer structure according to the first aspect of the invention, wherein Fig. 1a shows a section view of the layer structure and Fig. 1 b shows a bottom view;
Fig. 2 shows a second embodiment of a layer structure according to the first aspect of the invention;
Fig. 3 shows a third embodiment of a layer structure according to the first aspect of the invention;
Fig. 4 shows a fourth embodiment of a layer structure according to the first aspect of the invention;
Fig. 5 shows a fifth embodiment of a layer structure according to the first aspect of the invention;
Fig. 6 shows a sixth (Fig. 6a) and seventh (Fig. 6b) embodiment of a layer structure according to the first aspect of the invention;
Fig. 7 shows a eighth embodiment of a layer structure according to the first aspect of the invention wherein Fig. 7a shows a section view of the layer structure and Fig. 7 b shows a bottom view;
Fig. 8 shows an embodiment of a method according to the third aspect of the invention.
Fig. 9 shows another embodiment of a method according to the third aspect of the invention.

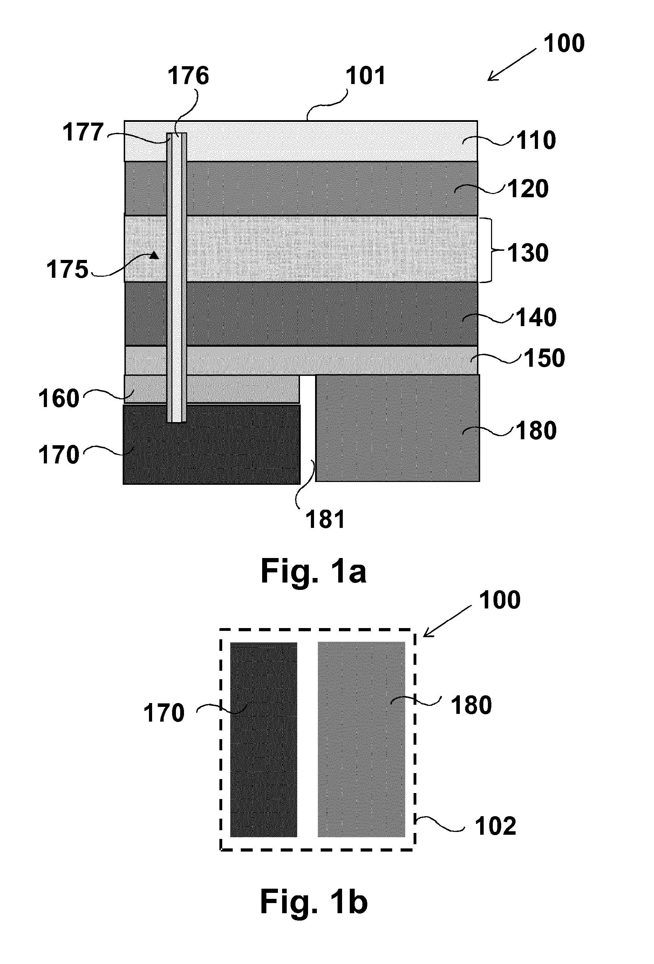

Fig. 1 shows an embodiment of a layer structure 100 according to the first aspect of the invention. Fig. 1a shows the layer structure in a cross-sectional view. The layer structure 100 can be used in a surface-emitting LED. The layer structure has an emission surface 101. The emission surface 101 is a surface of an anode layer 110. The anode layer 110 is made of a material, which is transparent for the light to be emitted. For example transparent conductive oxides like ITO or FTO can be used in the anode layer 110. A p-type layer 120 made of a first group-III-nitride material is arranged under the anode layer 110 on the opposite side of the anode layer 110 than the emission surface 101. In this embodiment the p-type layer is made of GaN. Other group-III-nitride materials are also suitable. An active group-III-nitride layer structure 130 is positioned under the p-type layer 120. The material of the p-type layer has a larger band-gap than the material of the active group-III-nitride layer structure 130 and is transparent for the light to be emitted. The active group-III-nitride layer structure 130 in the shown embodiment is a multi-quantum well structure comprising InGaN as material of the well layers. In further embodiments the active layer structure is a single active layer. Under the active group-III-nitride layer structure 130 an n-type layer 140 made of a second group-III-nitride material is arranged. In the shown embodiment the second group-III-nitride material is GaN and thus the same material as the first group-III-nitride material. The use of different group-III-nitride materials in p-type layer 130 and n-type layer 140 is also suitable. Under the n-type layer 140 a metal mirror cathode layer 150 is arranged, which reflects the light to be emitted. This improves the light extraction efficiency of the layer structure. Under parts of the metal mirror cathode layer 150 an isolation layer 160 is arranged. The isolation layer 160 serves as electrical isolation between the metal mirror cathode layer 150 and a metallically conductive anode contact substrate 170, which is herein realized as a blanket contact. At parts of the metal mirror cathode layer 150 not covered by the isolation layer 160 a metallically conductive cathode contact substrate 180 in the form of a blanket contact is directly arranged under the metal mirror cathode layer 150. The cathode contact substrate 180 is electrically connected to the metal mirror cathode layer 150. In this embodiment the anode contact substrate 170 and the cathode contact substrate 180 are arranged at a lateral distance from each other, thus leaving a gap 181. In a further embodiment, which is not shown in this drawing, the gap 181 between anode contact substrate 170 and cathode contact substrate 180 is filled with a dielectric material. The anode and cathode contact substrate both have a suitable thickness to provide mechanical support to the layer structure 100. They may also provide good heat dissipation during operation of the device.

The anode contact substrate 170 is electrically connected to the anode layer 110 through a Via 175, which, as shown, may protrude into the anode contact substrate 170 and/or into the anode layer 110. The use of several Vias for the electrical connection between the anode layer 110 and the anode contact substrate 170 is also suitable. The Via 175 has a passivation and isolation layer 177 on an inner wall of a Via channel in which it is arranged. The Via 175 is filled with a conductive material 176, for example ITO.

Fig. 1b shows a bottom view of the layer structure 100. The arrangement of the anode contact substrate 170 and the cathode contact substrate 180 in relation to a later chip perimeter 102 is shown. The anode contact substrate 170 and the cathode contact substrate 180 cover large areas of the chip parameter. They are able to stabilize the layer structure and meanwhile provide large electrical contact faces for easy applying an operational voltage to the layer structure using an external voltage supply.

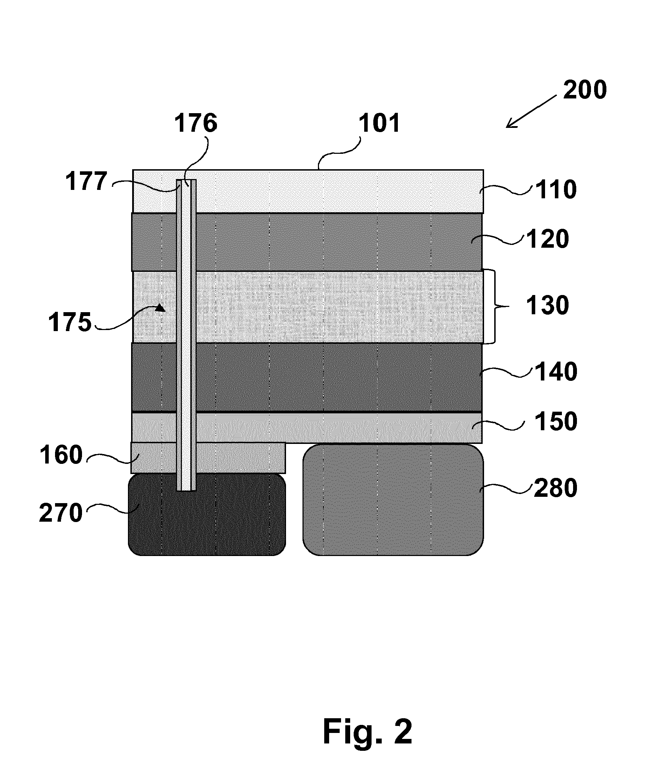

The layer structure 100 shown in Figs. 1a and 1b provides a p-side up light-emitting structure with the anode and cathode contacts positioned at that side of the layer structure, which is opposite to the emitting surface, thus achieving a particularly high light extraction efficiency. The further embodiments shown in the Fig. 2 to Fig. 7 also in cross-sectional view exhibit very similar layer structures compared to the embodiment of Fig. 1. Therefore, the following description focuses on differences in the further embodiments in comparison with that of Fig. 1. For features identical to the respective feature in Fig. 1 identical reference signs are used in the following.

Fig. 2 shows a second embodiment of a layer structure 200 according to the first aspect of the invention. In this embodiment the anode contact substrate 270 and the cathode contact substrate 280 are realized as bumps. Bumps can be fabricated in a fast and cost-efficient manner. The related processes are known from the prior art. As an additional advantage, the use of bumps allows a reproducible and cost-efficient snap breaking for die singulation in the subsequent singulation and packaging processes after the fabrication of the layer structure.

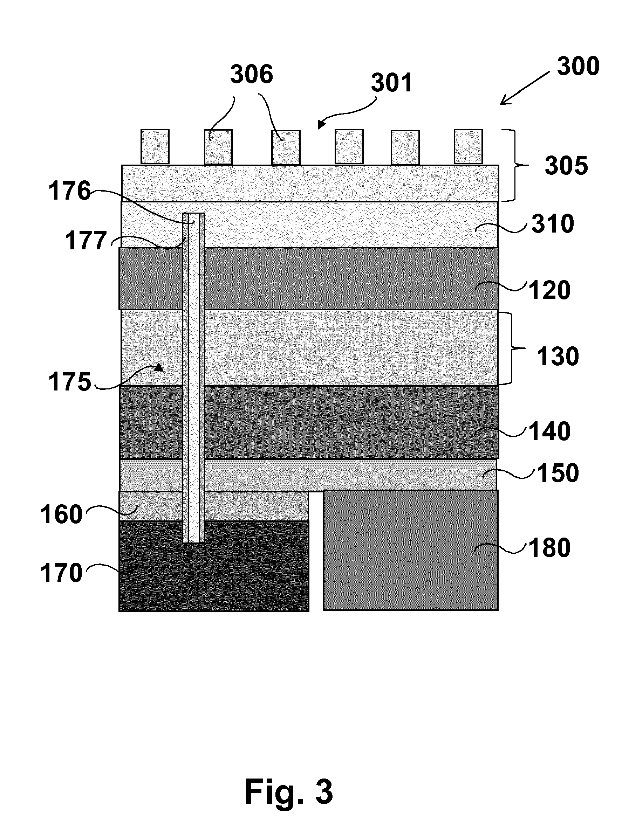

Fig. 3 shows a further embodiment of a layer structure according to the first aspect of the invention. An additional dielectric layer 305 is deposited on the anode layer 310. The dielectric layer 305 has a micro-structured emission surface 301 which is symbolized in the figure by the elevations 306. The elevations 306 are not presented true to scale. The micro-structuring, which is in this embodiment shown as a periodically structuring, but can also be a stochastic structuring, e.g. roughening, improves the light extraction efficiency and can additionally improve the light extraction directionality. A suitable material for the dielectric layer 305 is for example titanium dioxide (TiO₂).

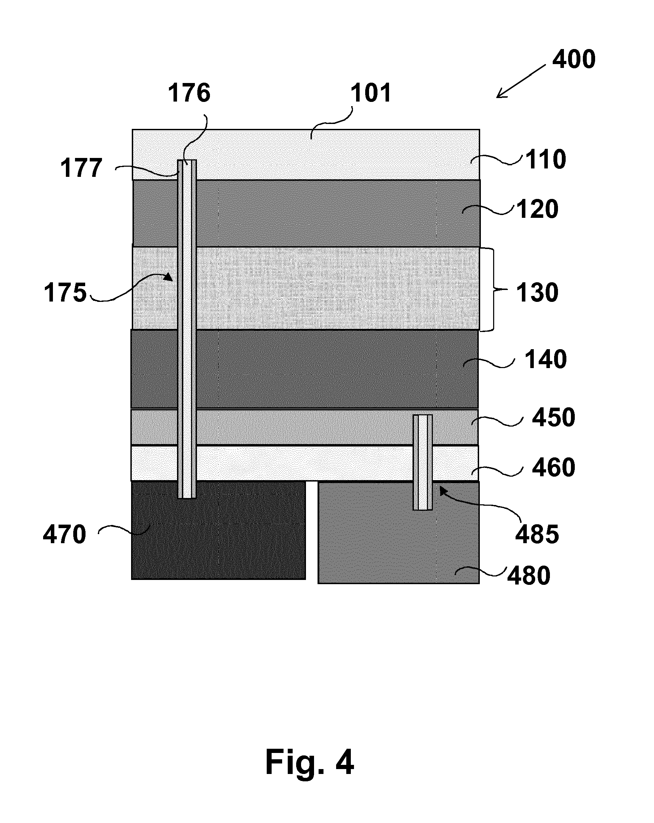

Fig. 4 shows a fourth embodiment of a layer structure 400 according to the first aspect of the invention. In this embodiment the isolation layer 460 is a distributed bragg reflector (DBR) layer and arranged in a way that the whole cathode layer 450 is covered by the isolation layer 460. The cathode layer 450 is made of a transparent conductive material in this embodiment, for example a transparent conductive oxide. As the cathode contact substrate 480 in this embodiment can not be directly arranged under the cathode layer 450, the electrical connection between the cathode layer 450 and the cathode contact substrate 480 is realized using a Via 485. With this embodiment the light extraction efficiency can be further improved due to the use of the DBR layer.

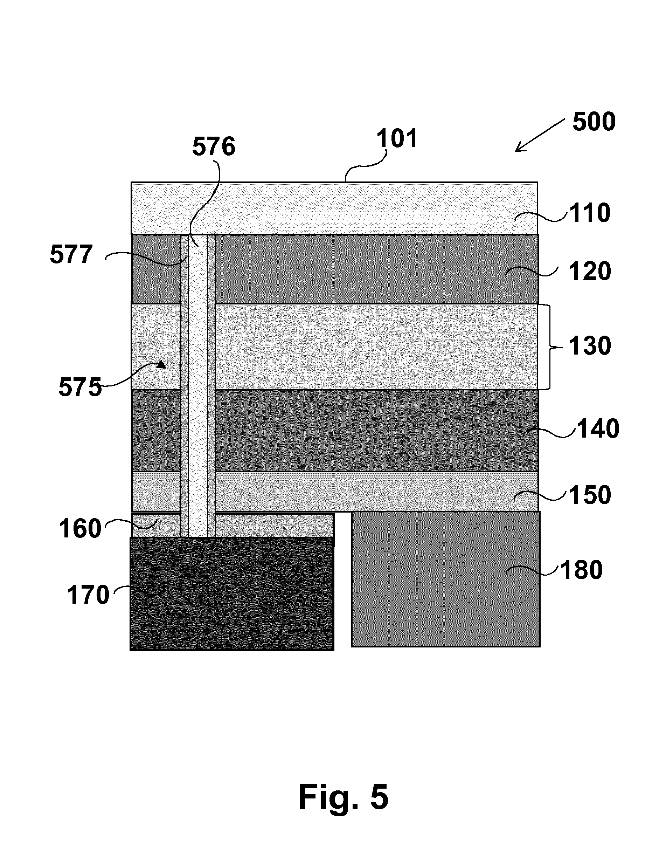

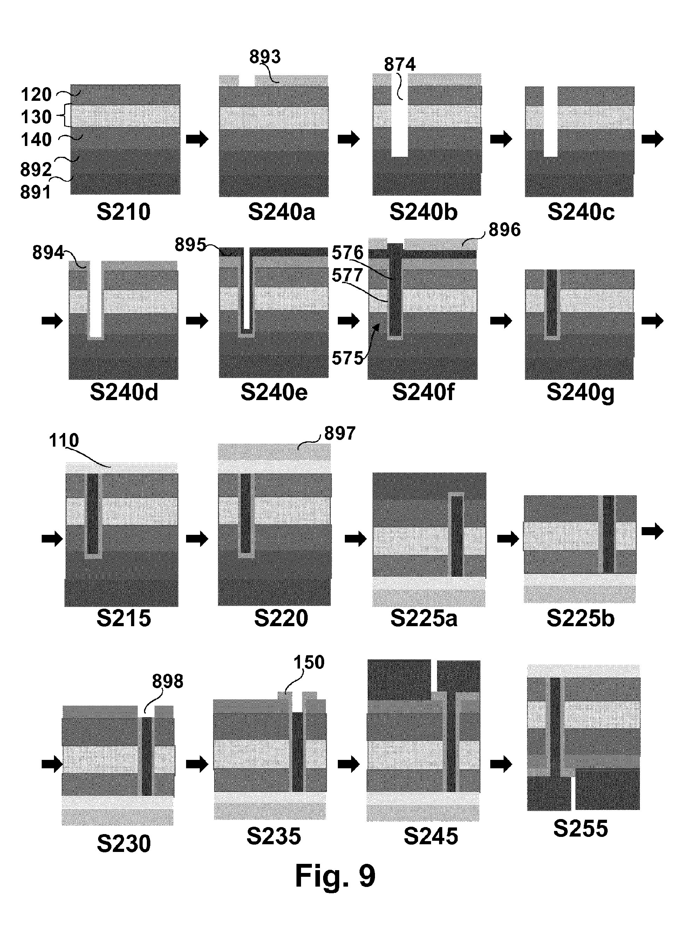

Fig. 5 shows a fifth embodiment of a layer structure 500 according to the first aspect of the invention. In this embodiment the vertical interconnect 575 comprises a passivation layer 577 made of an isolating material at the inner sidewall of a Via channel and a filling 576 with a conductive metal. As the filling 576 for the vertical interconnect a conductive oxide is also suitable. The vertical interconnect 575, electrically connecting the anode substrate 170 and the anode layer 110, extends in this embodiment from a surface of the anode substrate 170 to a surface of the anode layer 110 without protruding into the anode substrate 170 or the anode layer 110. This arrangement of the vertical interconnect is suitable to provide the electrical connection between the anode substrate 170 and the anode layer 110 while allowing an easier manufacturing by allowing planarized removing and etching steps. A method of manufacturing for this embodiment is shown in detail in Fig. 9.

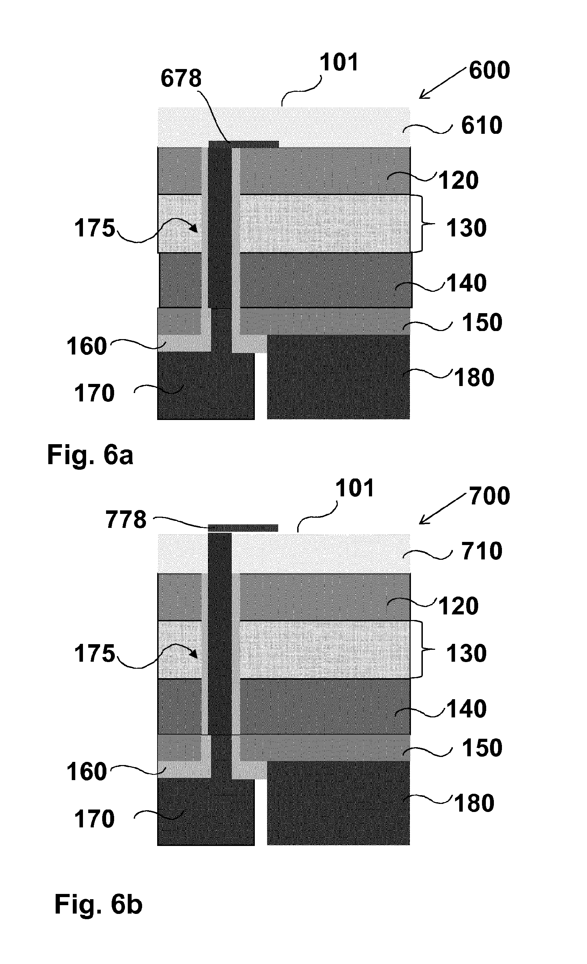

Fig. 6a shows a sixth embodiment of a layer structure 600 according to the first aspect of the invention. The layer structure 600 comprises an additional current spreading layer 678 arranged directly under the anode layer 610 and partially covering the anode layer 610. The current spreading layer improves the current spreading of the anode layer and as such the efficiency of the layer structure 600. Fig. 6b shows an alternative arrangement of the current spreading layer 778 in a seventh embodiment of a layer structure 700. In this embodiment the current spreading layer 778 is arranged on top of the anode layer 710.

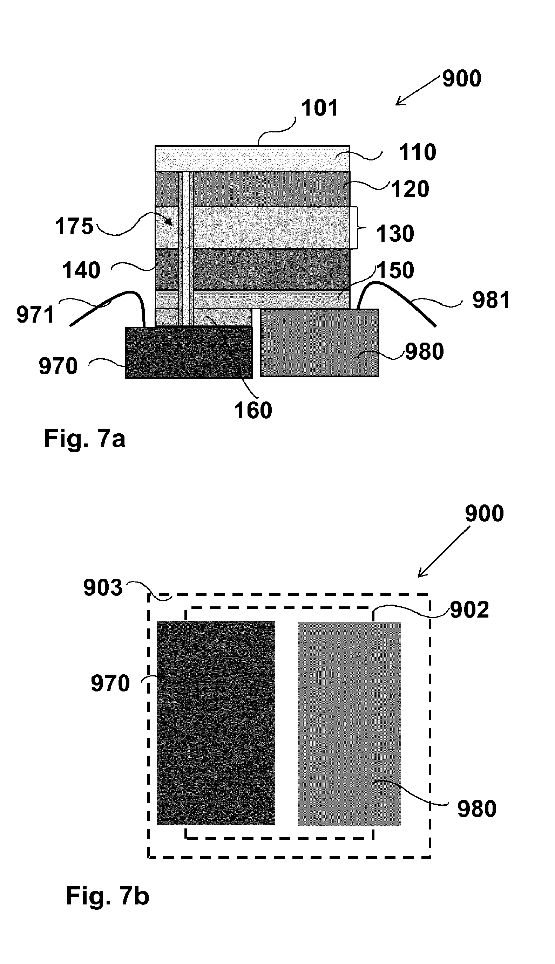

Fig. 7a shows an eighth embodiment of a layer structure 900 according to the first aspect of the invention. In this embodiment the anode substrate 970 and the cathode contact substrate 980 laterally exceed the lateral extension 902 of the layers arranged vertically over the anode substrate and the cathode contact substrate. This arrangement allows a contact of the anode substrate and the cathode contact substrate at their upper side, which can be easily realized. The anode substrate 970 and the cathode contact substrate 980 are in this embodiment contacted via bond wires 971, 981. The lateral extensions of the anode substrate 970 and the cathode contact substrate 980 are shown in Fig. 7b in a bottom view of the layer structure 900 with respect to the lateral extensions 902 of the layers arranged vertically over the anode substrate and the cathode contact substrate. Additionally, Fig. 7b shows a die singulation perimeter 903 for the layer structure for an embodiment of the fabrication method which comprises a die singulation after the deposition of both anode substrate and cathode contact substrate. In this embodiment the protruding part of the die singulation perimeter 903 in comparison to the lateral extensions 902 is removed in a further step.

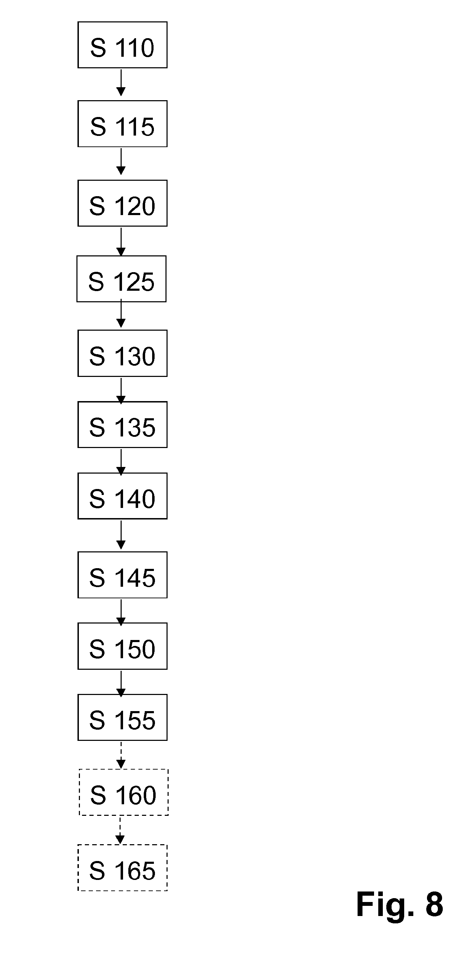

Fig. 8 shows a flow diagram of an embodiment of a method according to the third aspect of the invention. In step S110 a template is provided comprising on a growth substrate in order of layer deposition, an n-type layer made of a second group-III-nitride material, an active group-III-nitride layer structure configured to generate the light to be emitted in operation of the LED, and a p-type layer made of a first group-III-nitride material. In an embodiment the template comprises a buffer layer structure directly on a Si growth substrate. In step S115 an anode layer that is transparent for the light to be emitted is deposited on the p-type layer. Subsequently the compound consisting of the template and the anode layer is bonded to a temporary carrier at the anode layer side of the compound in S120. The whole compound is then flipped. In the next step S125 the growth substrate is removed and the n-type layer exposed. In the embodiment, in which a template comprising a buffer layer structure is used, for exposing the n-type layer the buffer layer structure is also removed. Additionally it is possible to slightly etch the exposed surface of the n-type layer in order to receive either a roughened or a smooth layer according to the requirements. Then a cathode layer is deposited on the n-type layer in step S130. Subsequently an isolation layer is deposited at least partially on the cathode layer in step S135. In step S140 at least one Via vertically extending through the isolation layer and to the anode layer is fabricated. This involves in one embodiment etching a channel vertically from the isolation layer to the anode layer, depositing a passivation and isolation coating on the inner-wall of the channel and filling the channel with a conductive material, additionally a certain thickness of the isolation layer can be etched off to provide an extension of the Via in excess of the isolation layer. In step S145 an anode contact substrate is deposited on the isolation layer and in electrical contact with the Via, the anode contact substrate can be deposited as a metal bump. In step S150 a cathode contact substrate is deposited either on the isolation layer or on the cathode layer. As well as the anode contact substrate, the cathode contact substrate can also be deposited as a metal bump. Further patterning of the bumps can also be performed. In step S155 the temporary carrier is removed and the layer structure is flipped once again. Thus the process can be called a double flip-chip process. Optionally a micro-structured dielectric layer can be deposited on the anode layer after removing the temporary carrier in step S160. In step S165 die singulation processes and packaging process can be performed in order to receive singularized devices. Suitable singulation and packaging process are known from the prior art.

The described process can be summarized as follows:

| | |
|---|---|
| S110 | Providing a template comprising a growth substrate, n-type layer, active layer and p-type layer |
| S115 | Deposition of an anode layer |
| S120 | Bonding to a temporary carrier and flip-chip |
| S125 | Removing of the growth substrate and exposing of the n-layer |
| S130 | Deposition of cathode layer |
| S135 | Deposition of isolation layer |
| S140 | Fabrication of at least one Via |
| S145 | Deposition of an anode contact substrate |
| S150 | Deposition of an cathode contact substrate |
| S155 | Removing of the temporary carrier |
| S160 | Deposition of a micro-structured |
| S165 | Die singulation processes and packaging processes |

Fig. 9 shows another embodiment of a method according to the third aspect of the invention as a sequence of cross-sectional views of a layer structure. In step S210 a template is provided comprising on a growth substrate, which comprises a Si substrate 891 and a buffer layer structure 892, in order of layer deposition, an n-type layer 140 made of a second group-III-nitride material, an active group-III-nitride layer structure 130 configured to generate the light to be emitted in operation of the LED, and a p-type layer 120 made of a first group-III-nitride material. In contrast to the embodiment of the method described in relation to Fig. 7 the fabrication of the at least one vertical interconnect is performed within the original template.

The fabrication of the vertical interconnect in form of a Via is in detail described in the following. In step S240a a photo resist layer 893 is deposited on the p-type layer 120 with exception of the area, where the further Via should be arranged. In step S240b an etching is performed, preferably a plasma-etching, forming a Via channel 874 extending through p-type layer 120, the active layer structure 130, the n-type layer 140 and into the buffer layer structure 892. The photoresist layer 893 is then removed (S240c). This removing step is performed simultaneously to the etching of the Via channel 874 in one embodiment. In step S240d a passivation layer 894 comprising an isolating material is deposited on the p-type layer 120 and on the inner side wall and bottom of the Via channel 874. In step S240e a seed layer 895 of a conductive material is deposited on the passivation layer 894. Additionally, a second photo resist layer 896 is deposited on the seed layer with exception of the area, where the further Via should be arranged. The Via channel is subsequently filled completely with the conductive material in the following step 240f. The photo resist layer 896, the part of the seed layer 895 and the part of the isolation layer 894 covered by the photoresist are then removed in step 240g, and the layer structure is planarized, either mechanically or chemically or in a combination of both in a CMP process.

In step S215 an anode layer that is transparent for the light to be emitted is deposited on the p-type layer. Subsequently the compound consisting of the template and the anode layer is bonded to a temporary carrier 897 at the anode layer side of the compound in S220. The whole compound is then flipped. In the next step S225a the growth substrate 891 is removed and the n-type layer exposed. In step S225b the buffer layer structure 892 is also removed.

In a variant not shown here, the exposed surface of the n-type layer 140 is slightly etched in order to receive either a roughened layer for improving the extraction efficiency. However, other variants have a smooth surface of the n-type layer 140.

Subsequently, in step S230 a metal cathode layer is deposited on the n-type layer, with exception to the Via area 898. Subsequently an isolation layer 150 is deposited at least partially on the cathode layer in step S235 both on the top of the cathode layer and on the sidewall of the Via channel build up by the cathode layer.

In step S245 an anode contact substrate is deposited on the isolation layer and in electrical contact with the Via, the anode contact substrate can be deposited as a metal bump and a cathode contact substrate is deposited on the cathode layer. In a similar manner as the anode contact substrate, the cathode contact substrate can be deposited as a metal bump. In step S255 the temporary carrier is removed and the layer structure is flipped once again.

### Reference list

- 100, 200, 400, 500, 600, 700, 900: layer structure
- 101: emission surface
- 102: chip perimeter
- 110, 310, 610, 710: anode layer
- 120: p-type layer
- 130: active layer structure
- 140: n-type layer
- 150, 450: cathode layer
- 160, 460,: isolation layer
- 170, 270, 970: anode contact substrate
- 180, 280, 480, 980: cathode contact substrate
- 175, 485, 575: Via
- 176, 576: filing with conductive material
- 177, 577, 894: passivation and isolation layer
- 181: gap
- 301: micro-structured emission surface
- 305: dielectric layer
- 306: elevations
- 678, 778: spreading layer
- 874: Via channel
- 891: growth substrate
- 892: buffer layer structure
- 893, 896: photo resist layer
- 895: seed layer
- 897: temporary carrier
- 898: Via area
- 902: lateral extension
- 903: singulation perimeter
- 971, 981: bond wires

## Claims

1. A layer structure (100) for a surface-emitting light-emitting diode, hereinafter LED, having an emission surface (101) that is closer to a p-side of the layer structure than to an n-side of the layer structure, and further comprising,
- an anode layer (110) that is transparent for the light to be emitted,
- a p-type layer (120) made of a first group-III-nitride material under the anode layer (110), that is, arranged at a larger distance from the emission surface (101) than the anode layer (110),
- an active group-III-nitride layer structure (130) under the p-type group-III-nitride layer and configured to generate the light to be emitted in operation of the LED,
- an n-type layer (140) made of a second group-III-nitride material under the active layer,
- a cathode layer (150) under the n-type layer (140),
- an electrically insulating isolation layer (160) arranged under the cathode layer (150),
- a metallically conductive anode contact substrate (170) arranged under the isolation layer (160) and electrically isolated from the cathode layer by the isolation layer ,
- at least one vertical interconnect (175), extending between and electrically connecting the anode contact substrate and the anode layer,
- a metallically conductive cathode contact substrate (180) that is electrically connected with the cathode layer (150) and arranged under cathode layer (150),
wherein either the isolation layer (160) or the cathode layer (150) is reflective for the light to be emitted, and wherein
either the cathode contact substrate (180) or the anode contact substrate (170) or both the cathode contact substrate and the anode contact substrate have a thickness that is suitable for forming a mechanical support of the layer structure.

2. The layer structure (100) of claim 1, wherein the cathode contact substrate (180) and the anode contact substrate (170) are arranged on a bottom surface of the layer structure and laterally separated by a either gap or a dielectric material filling.

3. The layer structure (100) of claim 1 or 2, wherein either the anode contact substrate (170) or the cathode contact substrate or the anode contact substrate and the cathode contact substrate (180) are bumps.

4. The layer structure (100) of one of the preceding claims, wherein a dielectric layer (305) is arranged on top of the anode layer (310), and wherein the dielectric layer (305) has a micro-structured emission surface (301).

5. The layer structure (100) of one of the preceding claims, wherein the cathode layer is made of a electrically conductive material that is transparent for the light to be emitted,
the isolating layer (160) is a distributed bragg reflector extending between the cathode layer (150) and the cathode contact substrate (180), and
the cathode contact substrate (180) and the cathode layer (150) are connected with each other through a vertical interconnect (175).

6. The layer structure of one of the claims 1 to 4, wherein the cathode layer (150) is a metal mirror layer (150) that is reflective for the light to be emitted.

7. The layer structure (100) of one of the preceding claims, wherein the lateral extension of the anode contact substrate (170), or the lateral extension of the cathode contact substrate (180), or the lateral extension of the anode contact substrate (170) and the lateral extension of the cathode contact substrate (180) exceed, in at least one lateral direction, the lateral extension of the layers arranged vertically over the anode contact substrate and the cathode contact substrate.

8. A method for fabricating a layer structure (100) for a surface-emitting light-emitting diode, hereinafter LED; the method comprising
- providing a template comprising, on a growth substrate in order of layer deposition, an n-type layer (140) made of a second group-III-nitride material, an active group-III-nitride layer structure (130) configured to generate the light to be emitted in operation of the LED, and a p-type layer made of a first group-III-nitride material,
- depositing an anode layer (110) that is transparent for the light to be emitted on the p-type layer (120),
- bonding the anode layer (110) to a temporary carrier,
- removing the growth substrate and exposing the n-type layer (140);
- depositing a cathode layer (150) on the n-type layer (140);
- depositing an isolation layer (160) at least partially on the cathode layer (150)
- fabricating at least one vertical interconnect (175), vertically extending through the isolation layer (160) and to the anode layer (110);
- depositing an anode contact substrate (170) on the isolation layer (160) and in electrical contact with the Via,
- depositing a cathode contact substrate (180) either on the isolation layer or on the cathode layer (150), and
- removing the temporary carrier (897).

9. The method of claim 8, wherein the template comprises a buffer layer structure (892) directly on a silicon growth substrate and wherein exposing the n-type layer (140) comprises removing the buffer layer structure (892) in addition to removing of the growth substrate.

10. The method of one of the claims 8 or 9, wherein depositing the anode contact substrate (170), or the cathode contact substrate (180), or both the anode contact substrate and the cathode contact substrate comprises depositing a metal bump.

11. The method of one of the claims 8 to 10, further comprising depositing a micro-structured dielectric layer (301) on the anode layer after removing the temporary carrier.

12. The method of one of the claims 8 to 11, further comprising depositing the isolation layer laterally covering the whole cathode layer (150), fabricating at least one additional via channel extending from the isolation layer (160) to the cathode layer (150) and depositing the cathode contact substrate (180) on the isolation layer (160).

13. A surface-emitting light-emitting diode, comprising the layer structure (100) of one of the claims 1 to 7.

14. The surface-emitting light-emitting diode of claim 13, further comprising submounts as packaging contacts.
